# EUROPEAN PATENT APPLICATION

(11) **EP 2 009 677 A1**
(43) Date of publication of application: **31.12.2008**
(21) Application number: 07739237.1
(22) Date of filing: 22.03.2007
(51) Int. Cl.: H01L 21/027

(54) **EXPOSURE DEVICE, DEVICE-MANUFACTURING METHOD, AND EXPOSING METHOD**

(30) Priority: 14.04.2006 JP 2006112573
(71) Applicant: Nikon Corporation, Tokyo 100-8331 (JP)
(72) Inventor: SHIGEMATSU, Koji, NIKON CORPORATION, Tokyo 100-8331 (JP)
(74) Representative: Hooiveld, Arjen Jan Winfried
(86) International application number: PCT/JP2007/055794
(87) International publication number: WO 2007/119466

(57) **Abstract**

An exposure apparatus is based on a relatively compact configuration and is a double exposure type of doubly printing two types of patterns in one shot area on the photosensitive substrate to form a synthetic pattern. An exposure apparatus has a first illumination system (ILa) which illuminates a first region elongated along Y-direction, in a pattern region formed in a first mask (Ma), a second illumination system (ILb) which illuminates a second region elongated along Y-direction, in a pattern region formed in a second mask (Mb) located apart from the first mask along X-direction, and a projection optical system (PL) which forms a pattern image of the first region and a pattern image of the second region in parallel along the second direction on a photosensitive substrate. An optical axis (AXa) of an exit-side partial optical system of the first illumination system and an optical axis (AXb) of an exit-side partial optical system of the second illumination system each are set along YZ.

## Description

### Technical Field

The present invention relates to an exposure apparatus, device manufacturing method, and exposure method and, particularly, to an exposure apparatus for manufacturing devices such as semiconductor devices, image pickup devices, liquid-crystal display devices, and thin-film magnetic heads by lithography.

### Background Art

The photolithography step for manufacturing the semiconductor devices and others is carried out using an exposure apparatus for projecting a pattern image of a mask (or reticle) through a projection optical system onto a photosensitive substrate (wafer or glass plate coated with a photoresist, or the like) to effect exposure thereof. The ordinary exposure apparatus forms one type of pattern in one shot area (unit exposure region) on the photosensitive substrate.

In contrast to it, an exposure apparatus of a double exposure type of doubly printing two types of patterns in one shot area on the photosensitive substrate to form a synthetic pattern is proposed (see Patent Document 1).

Patent Document 1: Japanese Patent Application Laid-open No. 2000-21748

### Disclosure of the Invention

### Problem to be Solved by the Invention

In an exposure apparatus of a double exposure type disclosed in Patent Document 1, it is required two illumination systems which illuminate independently, for example, two regions spaced from each other on a mask under required illumination conditions. In this case, it is important to avoid making the apparatus larger and to realize a compact configuration by taking sufficient consideration specially to the layout of two illumination systems.

The present invention was achieved in the view of the above problem and it is an object of the present invention to provide an exposure apparatus of the double exposure type capable of doubly printing, for example, two types of patterns in one shot area on a photosensitive substrate to form a synthetic pattern, based on a relatively compact configuration.

In order to solve the problem, a first embodiment of the present invention provides an exposure apparatus comprising:
a first illumination system which illuminates a first region elongated along a first direction, in a pattern region formed in a first mask;
a second illumination system which illuminates a second region elongated along the first direction, in a pattern region formed in a second mask located apart from the first mask along a second direction perpendicular to the first direction; and
a projection optical system which forms a pattern image of the first region and a pattern image of the second region in parallel along the second direction on a photosensitive substrate, or which forms the pattern image of the first region and the pattern image of the second region in accord with each other on the photosensitive substrate;
wherein an optical axis of an exit-side partial optical system of the first illumination system and an optical axis of an exit-side partial optical system of the second illumination system each are set along a plane parallel to the first direction.

A second embodiment of the present invention provides an exposure apparatus comprising:
a first illumination system which illuminates a first region elongated along a first direction, in a pattern region formed in a first mask;
a second illumination system which illuminates a second region elongated along the first direction, in a pattern region formed in a second mask located apart from the first mask along the first direction; and
a projection optical system which forms a pattern image of the first region and a pattern image of the second region in parallel along a second direction perpendicular to the first direction on a photosensitive substrate, or which forms the pattern image of the first region and the pattern image of the second region in accord with each other on the photosensitive substrate;
wherein an optical axis of an exit-side partial optical system of the first illumination system and an optical axis of an exit-side partial optical system of the second illumination system each are set along a plane parallel to the second direction.

A third embodiment of the present invention provides an exposure apparatus comprising:
a first illumination system which illuminates a first mask;
a second illumination system which illuminates a second mask located apart from the first mask along a first direction; and
a projection optical system which forms a pattern image of the first region and a pattern image of the second region in parallel on a photosensitive substrate, or which forms the pattern image of the first region and the pattern image of the second region in accord with each other on the photosensitive substrate;
wherein an exit-side partial optical system of the first illumination system and an exit-side partial optical system of the second illumination system are arranged next to each other and in parallel, and
wherein an optical axis of the exit-side partial optical system of the first illumination system and an optical axis of the exit-side partial optical system of the second illumination system each are set along a plane parallel to a second direction perpendicular to the first direction.

A fourth embodiment of the present invention provides a device manufacturing method comprising:
an exposure step of using the exposure apparatus of the first embodiment, the second embodiment, or the third embodiment to effect exposure of a pattern of the first mask and a pattern of the second mask on the photosensitive substrate; and
a development step of effecting development of the photosensitive substrate after the exposure step.

A fifth embodiment of the present invention provides an exposure method of using the exposure apparatus of the first embodiment, the second embodiment, or the third embodiment to effect exposure of a pattern of the first mask and a pattern of the second mask on the photosensitive substrate,
wherein, while moving the first mask, the second mask, and the photosensitive substrate along the second direction, scanning exposure of the pattern of the first mask and the pattern of the second mask is effected in a unit exposure region on the photosensitive substrate.

A sixth embodiment of the present invention provides an exposure method of using the exposure apparatus of the first embodiment, the second embodiment, or the third embodiment to effect exposure of a pattern of the first mask and a pattern of the second mask on the photosensitive substrate,
wherein, while moving the first mask, the second mask, and the photosensitive substrate along the second direction, scanning exposure of the pattern of the first mask is effected in one unit exposure region on the photosensitive substrate, and scanning exposure of the pattern of the second mask is effected in another unit exposure region located apart from said one unit exposure region along the second direction.

A seventh embodiment of the present invention provides an illumination apparatus comprising:
a first illumination system which illuminates a first region elongated along a first direction, in a pattern region formed in a first mask; and
a second illumination system which illuminates a second region elongated along the first direction, in a pattern region formed in a second mask located apart from the first mask along a second direction perpendicular to the first direction;
wherein an optical axis of an exit-side partial optical system of the first illumination system and an optical axis of an exit-side partial optical system of the second illumination system each are set along a plane parallel to the first direction, and
wherein the exit-side partial optical system of the first illumination system and the exit-side partial optical system of the second illumination system are arranged next to each other and in parallel.

An eighth embodiment of the present invention provides an illumination apparatus comprising:
a first illumination system which illuminates a first region elongated along a first direction, in a pattern region formed in a first mask; and
a second illumination system which illuminates a second region elongated along the first direction, in a pattern region formed in a second mask located apart from the first mask along the first direction;
wherein an optical axis of an exit-side partial optical system of the first illumination system and an optical axis of an exit-side partial optical system of the second illumination system each are set along a plane parallel to a second direction perpendicular to the first direction, and
wherein the exit-side partial optical system of the first illumination system and the exit-side partial optical system of the second illumination system are arranged next to each other and in parallel.

A ninth embodiment of the present invention provides a device manufacturing method comprising:
an exposure step of using the exposure apparatus of the seventh embodiment or the eighth embodiment to effect exposure of a pattern of the first mask and a pattern of the second mask on the photosensitive substrate; and
a development step of effecting development of the photosensitive substrate after the exposure step.

### Effect of the Invention

In the present invention, optical axes on exit-side of two illumination systems are respectively set along a plane parallel to the first direction which is the longitudinal direction of the illumination regions formed on each mask. In this case, the effective reflection regions of the reflectors for folding the optical path near the exit end of the illumination systems tend to become larger, however, it becomes feasible to arrange the two illumination systems in the compact form and in parallel with respect to the projection optical system and a pair of masks. As a result, the exposure apparatus of the present embodiment is able to form a synthetic pattern in one shot area on a photosensitive substrate, for example, by double printing of the two types of patterns therein, based on the relatively compact configuration and eventually to manufacture devices at high throughput.

### Brief Description of the Drawings

Fig. 1 is a drawing schematically showing a configuration of an
exposure apparatus according to an embodiment of the present invention.
Fig. 2 is a drawing showing a state in which a pair of illumination systems are arranged in parallel in the exposure apparatus of Fig. 1.
Fig. 3 is a perspective view showing a state of the exposure apparatus according to the embodiment shown in Figs. 1 and 2.
Fig. 4 is a drawing schematically showing a positional relation of a double-headed projection optical system with two masks.
Fig. 5(a) is a drawing showing the rectangular illumination regions formed on the first mask and on the second mask, respectively, and fig. 5(b) is a drawing showing the pattern image of the first mask and the pattern image of the second mask formed through the projection optical system.
Fig. 6(a) is a drawing showing the pair of rectangular illumination regions in the modification example of the layout different from the embodiment, and fig. 6(b) is a drawing showing the pair of pattern images formed through the projection optical system in the modification example.
Fig. 7 is a drawing schematically showing a configuration of illumination systems according to a modification example of the embodiment.
Fig. 8 is a perspective view showing a state of an exposure apparatus according to the modification example shown in Fig. 7.
Fig. 9 is a drawing showing a configuration of a double-headed projection optical system consisting of refracting systems and folding mirrors.
Fig. 10 is a drawing schematically showing a configuration of a catadioptric and double-headed projection optical system.
Fig. 11 is a drawing schematically showing a configuration of a double-headed projection optical system using a beam splitter.
Fig. 12 is a flowchart of a technique of manufacturing semiconductor devices as micro devices.
Fig. 13 is a flowchart of a technique of manufacturing a liquid-crystal display device as a micro device.

### Description of Reference Symbols

1a, 1b light source
2a, 2b first optical system
3a, 3b fly's eye lens
4a, 4b second optical system
4aa, 4ba, 7 optical path-folding reflector
5a, 5b aperture stop
6 optical splitter (polarization beam splitter)
ILa, ILb illumination system
Ma, Mb mask
PL projection optical system
W wafer

### Best Modes for Carrying Out the Invention

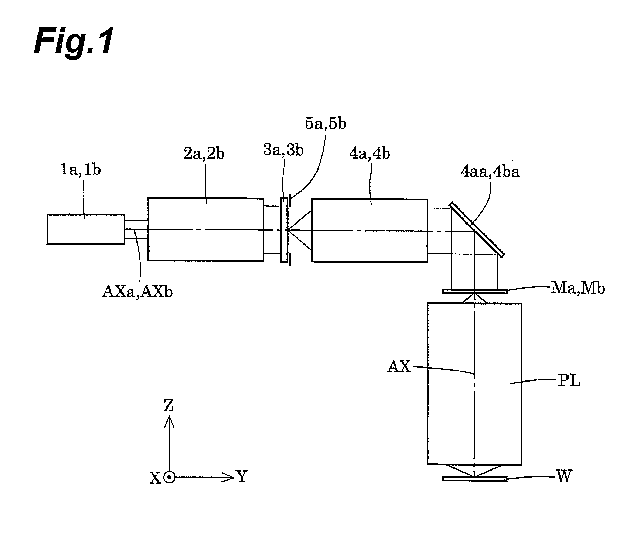

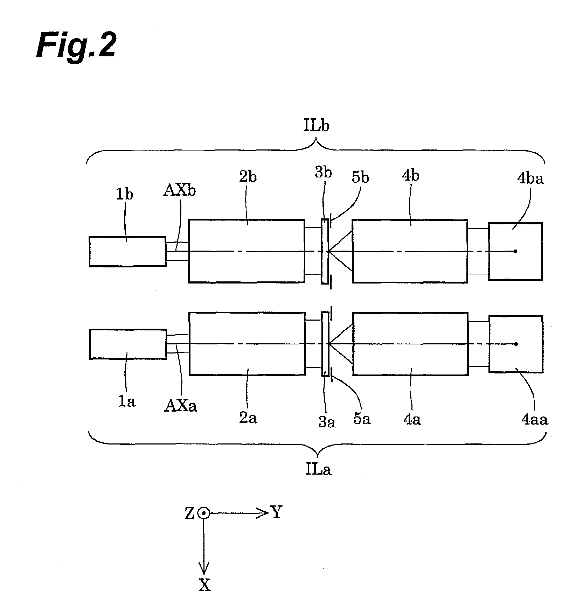

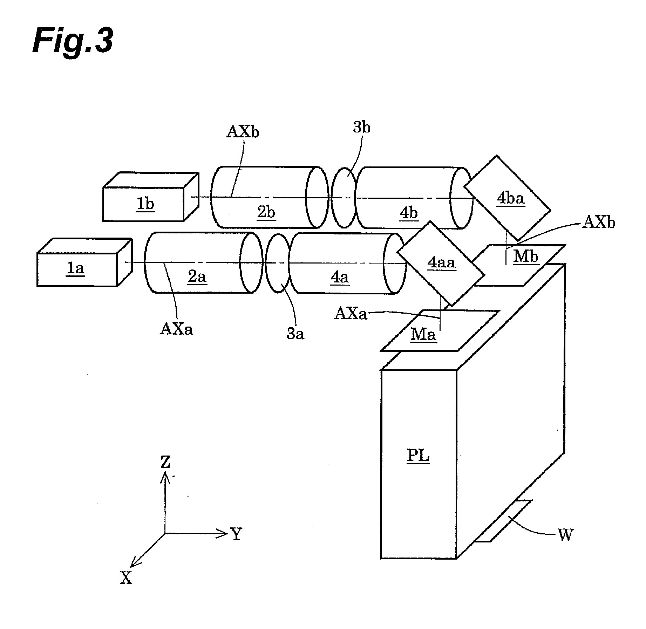

Embodiments of the present invention will be described on the basis of the accompanying drawings. Fig. 1 is a drawing schematically showing a configuration of an exposure apparatus according to an embodiment of the present invention. Fig. 2 is a drawing showing a state in which a pair of illumination systems are arranged in parallel in the exposure apparatus of Fig. 1. Fig. 3 is a perspective view showing a state of the exposure apparatus according to the embodiment shown in Figs. 1 and 2. In Fig. 1, the Z-axis is set along a direction of a normal to a wafer W being a photosensitive substrate, the Y-axis along a direction parallel to the page of Fig. 1 in the plane of the wafer W, and the X-axis along a direction perpendicular to the page of Fig. 1 in the plane of the wafer W.

With reference to Figs. 1, 2, and 3, the exposure apparatus of the present embodiment is provided with two illumination systems ILa and ILb having their respective optical axes AXa and AXb set along the YZ plane (plane parallel to the Y-direction and perpendicular to the X-direction). Since the first illumination system ILa and the second illumination system ILb arranged in parallel have the same configuration, the configuration and action of each illumination system will be described below while focusing our attention to the first illumination system ILa, and corresponding reference symbols of the second illumination system and its components will be given in parentheses.

The first illumination system ILa (second illumination system ILb) has a light source 1a (1b) for supplying exposure light (illumination light), a first optical system 2a (2b), a fly's eye lens (or micro fly's eye lens) 3a (3b), and a second optical system 4a (4b). The light source 1a (1b) applicable herein is, for example, an ArF excimer laser light source for supplying light having the wavelength of about 193 nm, or a KrF excimer laser light source for supplying light having the wavelength of about 248 nm.

A nearly parallel beam emitted from the light source 1a (1b) travels through the first optical system 2a (2b) to enter the fly's eye lens 3a (3b). The first optical system 2a (2b) has, for example, a beam transmitting system (not shown) having a well-known configuration, and a polarization state varying part (not shown). The beam transmitting system has functions of guiding the beam to the polarization state varying part while converting the incident beam into a beam having a cross section of an appropriate size and shape, and actively correcting positional variation and angular variation of the beam incident to the polarization state varying part.

The polarization state varying part has a function of varying a polarization state of the illumination light incident to the fly's eye lens 3a (3b). Specifically, the polarization state varying part is composed, for example, of the following components in order from the light source side: a half wave plate made of rock crystal, an angle-deviation prism of rock crystal or rock-crystal prism, and an angle-deviation prism of silica glass or silica prism. Each of the half wave plate, rock-crystal prism, and silica prism is arranged to be rotatable around the optical axis AXa (AXb). The rock-crystal prism has a depolarizing action and the silica prism has a function of correcting curvature of rays due to the angle-deviation action of the rock-crystal prism.

As the direction of the crystallographic axis of the half wave plate and the direction of the crystallographic axis of the rock-crystal prism are appropriately set, the polarization state varying part converts linearly polarized light coming from the beam transmitting system, into linearly polarized light having a different vibration direction, converts the incident linearly polarized light into unpolarized light, or directly outputs the incident linearly polarized light without conversion. After the polarization state is varied according to need by the polarization state varying part, the beam is then incident to the fly's eye lens 3a (3b).

The beam entering the fly's eye lens 3a (3b) is two-dimensionally split by a large number of small lens elements to form small light sources on rear focal planes of the respective small lens elements into which the beam is incident. In this way, a substantial surface illuminant consisting of a large number of small light sources is formed on the rear focal plane of the fly's eye lens 3a (3b). Beams from the fly's eye lens 3a (3b) are guided via the second optical system 4a (4b) to a first mask Ma (second mask Mb).

The second optical system 4a (4b) has, for example, a condenser optical system (not shown) having a well-known configuration, a mask blind (not shown), an imaging optical system (not shown), an optical path-folding reflector 4aa (4ba) as a folding member, and so on. In this case, the beams from the fly's eye lens 3a (3b) travel through the condenser optical system and thereafter illuminate the mask blind in a superimposed manner. An illumination field of a rectangular shape according to the shape of each small lens element forming the fly's eye lens 3 a (3b) is formed on the mask blind as an illumination field stop.

After passing through a rectangular aperture (optically transparent part) of the mask blind, the beams then travel via the imaging optical system and optical path-folding reflector 4aa (4ba) to illuminate the first mask Ma (second mask Mb) in a superimposed manner. An aperture stop 5a (5b) for restricting the beams from the fly's eye lens 3a (3b) is located near the exit plane of the fly's eye lens 3a (3b). The aperture stop 5a (5b) has a function of varying the size and shape of a light intensity distribution near the exit plane of the fly's eye lens 3a (3b), i.e., on the illumination pupil (which will be referred to hereinafter as "pupil intensity distribution").

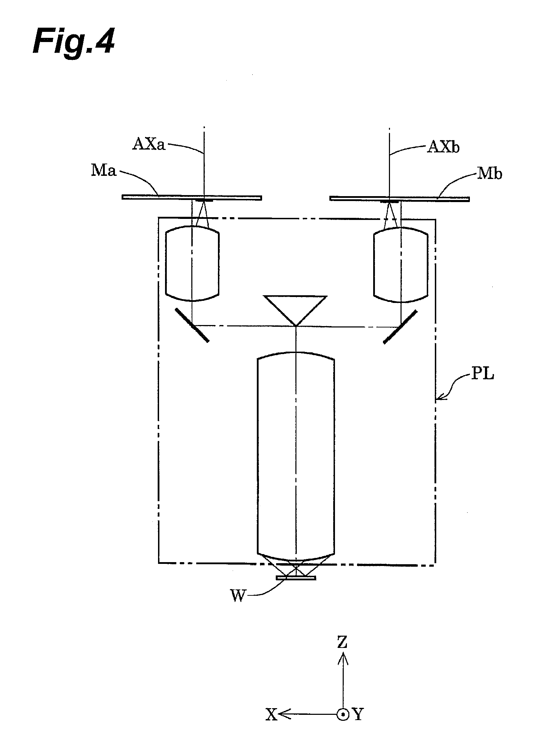

A beam transmitted by the first mask Ma and a beam transmitted by the second mask Mb travel, as shown in Fig. 4, through a double-headed projection optical system PL, for example, consisting of refracting systems and folding mirrors, to form a pattern image of the first mask Ma and a pattern image of the second mask Mb on a wafer (photosensitive substrate) W. The double-headed projection optical system PL is an optical system having two effective fields spaced from each other, and one effective imaging region.

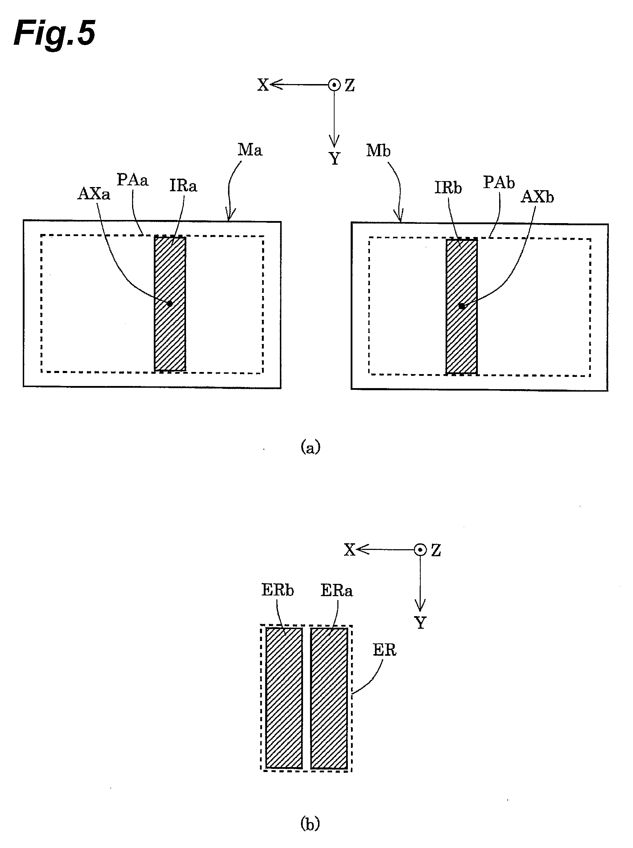

In the present embodiment, as shown on the left side of Fig. 5(a), the first illumination system ILa forms a rectangular illumination region IRa elongated along the Y-direction on the first mask Ma. The second illumination system ILb forms a rectangular illumination region IRb elongated along the Y-direction on the second mask Mb, as shown on the right side of Fig. 5 (a). The first illumination region IRa and the second illumination region IRb each are formed, for example, as centered on the optical axis AXa of the first illumination system ILa and on the optical axis AXb of the second illumination system ILb, respectively.

Namely, in a pattern region PAa of the first mask Ma, a pattern corresponding to the first illumination region IRa is illuminated in a polarization state set by the polarization state varying part in the first illumination system ILa and under an illumination condition defined by the size and shape of the pupil intensity distribution set by the aperture stop 5a. Furthermore, in a pattern region PAb of the second mask Mb located apart from the first mask Ma along the X-direction, a pattern corresponding to the second illumination region IR2 is illuminated in a polarization state set by the polarization state varying part in the second illumination system ILb and under an illumination condition defmed by the size and shape of the pupil intensity distribution set by the aperture stop 5b. In this manner, the polarization state varying part and aperture stop 5a in the first illumination system ILa constitute a first setting part for setting the first illumination region IRa in the first illumination condition, and the polarization state varying part and aperture stop 5b in the second illumination system ILb constitute a second setting part for setting the second illumination region IRb in the second illumination condition. In addition, the polarization state varying parts and aperture stops 5a, 5b constitute an illumination condition varying part for varying the illumination conditions for illumination of the first illumination region IRa and the second illumination region IR2.

In this manner, as shown in Fig. 5 (b), a pattern image of the first mask Ma illuminated by the first illumination region IRa is formed in a first region ERa of a rectangular shape elongated along the Y-direction in an effective imaging region ER of the projection optical system PL, and a pattern image of the second mask Mb illuminated by the second illumination region IRb is formed in a second region ERb having a rectangular contour shape elongated similarly along the Y-direction and located in parallel in the X-direction to the first region ERa in the effective imaging region ER. More specifically, when the projection optical system PL is viewed from right above it along the Z-direction being the vertical direction, the pattern image of the first illumination region IRa of the first mask Ma and the pattern image of the second illumination region IRb of the second mask Mb are formed in parallel in a region between the first illumination region IRa formed by the first illumination system ILa and the second illumination region IRb formed by the second illumination system ILb.

In the present embodiment, while the first mask Ma, the second mask Mb, and the wafer W are synchronously moved along the X-direction relative to the projection optical system PL, double scanning exposure of the pattern of the first mask Ma and the pattern of the second mask Mb is implemented in one shot area on the wafer W to form a synthetic pattern. The aforementioned double scanning exposure is repeated with two-dimensional step movement of the wafer W along the XY plane relative to the projection optical system PL, whereby synthetic patterns of the pattern of the first mask Ma and the pattern of the second mask Mb are sequentially formed in respective shot areas on the wafer W.

In the present embodiment, as described above, the rectangular illumination regions IRa and IRb elongated along the Y-direction are formed on the first mask Ma and on the second mask Mb located apart from each other along the X-direction, and the pattern image of the first illumination region IRa of the first mask Ma and the pattern image of the second illumination region IRb of the second mask Mb are formed in parallel along the X-direction on the wafer W. There are the two illumination systems ILa, ILb arranged in parallel and they have the optical axes AXa, AXb parallel to each other along the YZ plane parallel to the Y-direction (first direction), which is the longitudinal direction of the illumination regions IRa, IRb formed on the masks Ma, Mb, and perpendicular to the X-direction (second direction) and have the same configuration.

In this case, the effective reflection regions of the reflectors 4aa, 4ba for folding the optical path near the exit end of the illumination systems ILa, ILb tend to become larger, and this tends to lead to an increase in the size of the optical path-folding reflectors 4aa, 4ba; however, it becomes feasible to arrange the two illumination systems ILa, ILb in the compact form and in parallel with respect to the projection optical system PL and the masks Ma, Mb. As a result, the exposure apparatus of the present embodiment is able to form a synthetic pattern in one shot area on the wafer (photosensitive substrate) W by double printing of the two types of mask patterns therein, based on the relatively compact configuration.

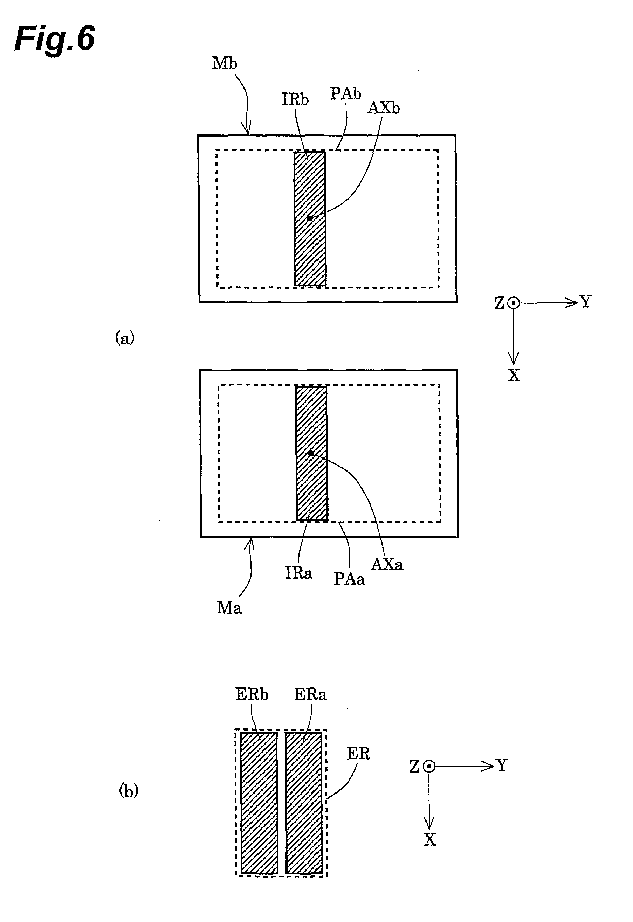

In the above-described embodiment, the optical axes AXa, AXb of the two illumination systems ILa, ILb each are set along the plane (YZ plane) parallel to the longitudinal direction (Y-direction) of the rectangular illumination regions IRa, IRb formed on the first mask Ma and on the second mask Mb, and the first mask Ma and the second mask Mb are located apart from each other along the transverse direction (X-direction) of the illumination regions IRa, IRb. However, without having to be limited to this, it is also possible to adopt a modification example of such a layout, as shown in Fig. 6 (a), that the illumination regions IRa, IRb of the rectangular shape with the shorter sides along the YZ plane, on which the optical axes AXa, AXb of the two illumination systems ILa, ILb are set, are formed on the respective masks Ma, Mb and that the masks Ma and Mb are located apart from each other along the longitudinal direction (X-direction) of the illumination regions IRa, IRb.

In the modification example of the layout shown in Fig. 6, as shown in Fig. 6 (b), the pattern image of the first mask Ma illuminated by the first illumination region IRa is formed in the first region ERa of the rectangular shape elongated along the X-direction in the effective imaging region ER of the unrepresented projection optical system PL, and the pattern image of the second mask Mb illuminated by the second illumination region IRb is formed in the second region ERb having the contour shape of the rectangular shape elongated similarly along the X-direction, and located in parallel in the Y-direction to the first region ERa in the effective imaging region ER. More specifically, when the projection optical system PL is viewed from right above it along the Z-direction being the vertical direction, the pattern image of the first illumination region IRa of the first mask Ma and the pattern image of the second illumination region IRb of the second mask Mb are formed in parallel in the region between the first illumination region IRa formed by the first illumination system ILa and the second illumination region IRb formed by the second illumination system ILb.

In the modification example of Fig. 6, while the first mask Ma, second mask Mb, and wafer W are synchronously moved along the Y-direction relative to the projection optical system PL, double scanning exposure of the pattern of the first mask Ma and the pattern of the second mask Mb is implemented in one shot area on the wafer W to form a synthetic pattern. In the modification example of Fig. 6, as in the case of the aforementioned embodiment, the two-illumination systems ILa, ILb can be arranged in the compact form and in parallel with respect to the projection optical system PL and the masks Ma, Mb. In the modification example of Fig. 6, different from the case of the aforementioned embodiment, the optical axes AXa, AXb of the illumination systems ILa, ILb are set along the YZ plane parallel to the longitudinal direction of the illumination regions IRa, IRb formed on the masks Ma, Mb, whereby the optical path-folding reflectors 4aa, 4ba can be formed in a relatively compact shape.

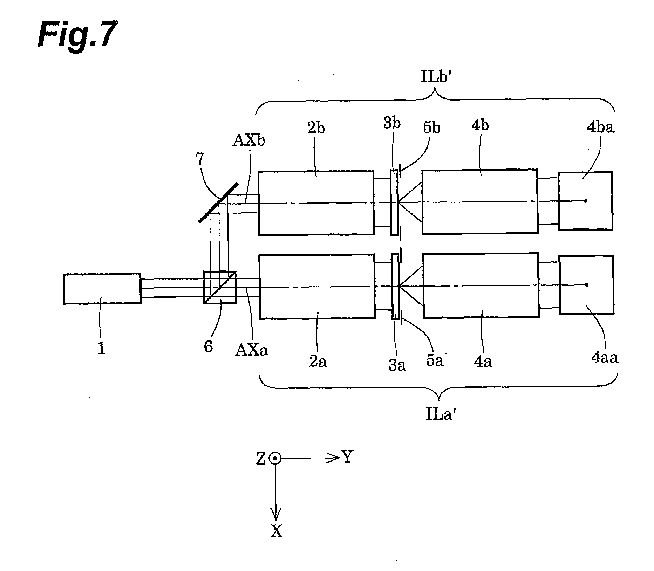

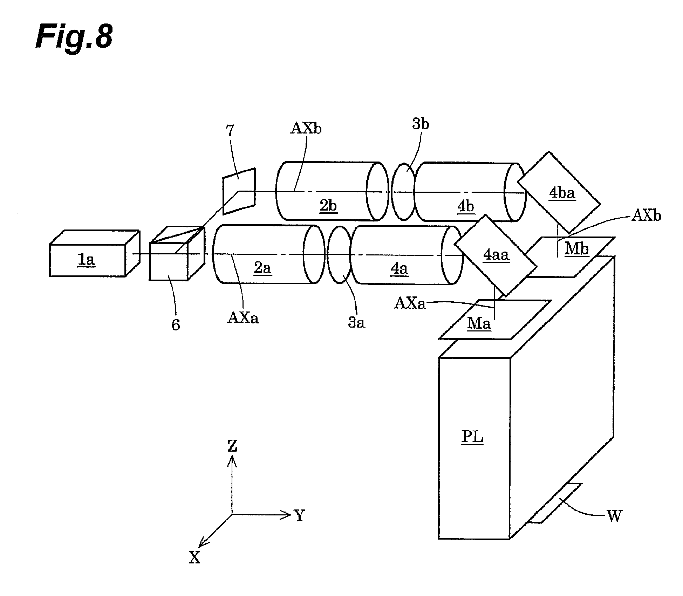

In the aforementioned embodiment and the modification example of Fig. 6, the two illumination systems ILa and ILb have the same configuration, and each of the optical axis AXa of the entire first illumination system ILa and the optical axis AXb of the entire second illumination system ILb is set along the YZ plane. However, without having to be limited to this, it is also possible to adopt a modification example, as shown in Fig. 7, wherein the first illumination system and the second illumination system have a common light source 1, and an optical splitter 6 which splits light from this common light source 1 into light traveling toward the optical path of the first illumination system and light traveling toward the optical path of the second illumination system. Fig. 8 is a perspective view showing a state of an exposure apparatus according to the modification example shown in Fig. 7.

In the modification example of Figs. 7 and 8, a nearly parallel beam emitted along the Y-direction from the common light source 1, e.g., an ArF excimer laser light source or a KrF excimer laser light source is incident to the optical splitter 6 such as a polarization beam splitter. A p-polarized beam transmitted by the polarization beam splitter 6 is guided to the first optical system 2a of the first illumination system. On the other hand, an s-polarized beam reflected into the -X-direction by the polarization beam splitter 6 is reflected into the +Y-direction by an optical path-folding reflector 7 to be guided to the first optical system 2b of the second illumination system.

In the modification example of Figs. 7 and 8, as described above, the optical axis AXa of the partial optical system ILa' of the first illumination system located between the optical splitter 6 and the first mask Ma and the optical axis AXb of the partial optical system ILb' of the second illumination system located between the optical splitter 6 and the second mask Mb each are set along the YZ plane parallel to the Y-direction. As a result, in the modification example of Figs. 7 and 8, as in the case of the aforementioned embodiment and the modification example of Fig. 6, the two illumination systems can be arranged in the compact form and in parallel with respect to the projection optical system PL and the masks Ma, Mb.

In the foregoing embodiment and the modification example of Fig. 6, the rectangular first illumination region IRa and second illumination region IRb each are formed as centered on the optical axis AXa of the first illumination system ILa and on the optical axis AXb of the second illumination system ILb. However, without having to be limited to this, it is also possible to adopt various forms as to the contour shape of the illumination regions IRa, IRb, the positional relation of the illumination regions IRa, IRb relative to the optical axes AXa, AXb, and so on.

In the foregoing embodiment and the modification example of Fig. 6, the present invention was described in association with the double exposure to form a synthetic pattern by double printing of the two types of patterns in one shot area on the photosensitive substrate (wafer). However, without having to be limited to this, the present invention is also applicable similarly to multiple exposure to form a synthetic pattern by multiple printing of three or more types of patterns in one shot area on the photosensitive substrate.

In the foregoing embodiment and the modification example of Fig. 6, a synthetic pattern is formed in one shot area on the photosensitive substrate by double scanning exposure of the first pattern and the second pattern. However, without having to be limited to this, it is also possible to adopt a method of effecting scanning exposure or full-field exposure of the first pattern in a first shot area on the photosensitive substrate and effecting scanning exposure or full-field exposure of the second pattern in a second shot area on the photosensitive substrate.

In the foregoing embodiment and the modification example of Fig. 6, the pattern image of the first illumination region of the first mask and the pattern image of the second illumination region of the second mask are formed in parallel on the photosensitive substrate. However, without having to be limited to this, it is also possible to use a projection optical system which forms the pattern image of the first illumination region of the first mask and the pattern image of the second illumination region of the second mask in accord with each other on the photosensitive substrate and thereby to form a synthetic pattern in one shot area on the photosensitive substrate by double scanning exposure or full-field exposure of the first pattern and the second pattern.

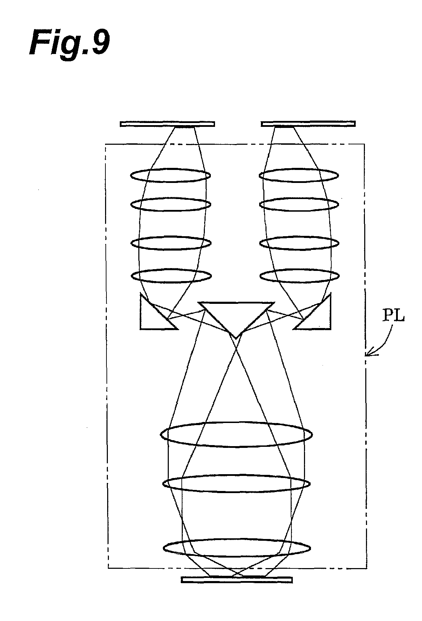

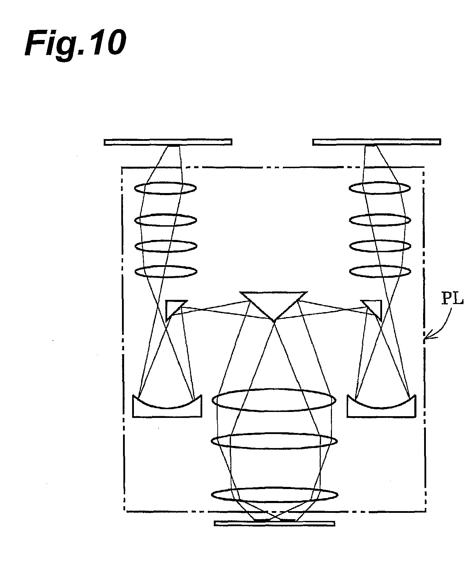

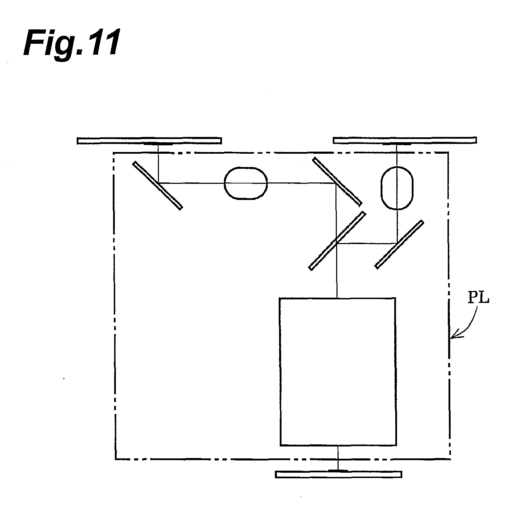

The embodiment of Fig. 1 and the modification example of Fig. 6 use the double-headed projection optical system consisting of refracting systems and folding mirrors. However, without having to be limited to this, it is also possible to use a double-headed projection optical system PL of another type consisting of refracting systems and folding mirrors, for example, as shown in Fig. 9, or to use a catadioptric and double-headed projection optical system PL as shown in Fig. 10. It is also possible to use a double-headed projection optical system PL using a beam splitter as shown in Fig. 11, as a projection optical system which forms the pattern image of the first illumination region of the first mask and the pattern image of the second illumination region of the second mask in accord with each other on the photosensitive substrate.

In each embodiment described above, the exit-side partial optical system of the first illumination system is the optical system (4a, 4aa) located downstream the fly's eye lens 3a as an optical integrator, or downstream the aperture stop 5a, and the exit-side partial optical system of the second illumination system is the optical system (4b, 4ab) located downstream the fly's eye lens 3b as an optical integrator, or downstream the aperture stop 5b. The exit-side partial optical systems of the first and second illumination systems are arranged in parallel and next to each other along the Y-direction perpendicular to the X-direction in which the first mask Ma and the second mask Mb are located apart from each other, and the optical axes (AXa, AXb) of the exit-side partial optical systems of the first and second illumination systems each are arranged along the plane (plane parallel to the YZ plane) parallel to the Y-direction perpendicular to the X-direction in which the first mask Ma and the second mask Mb are located apart from each other. By adopting this configuration, the first and second illumination systems can be intensively arranged in the compact form in spite of the double exposure apparatus configuration. Particularly, as the first illumination system and the second illumination system are arranged next to each other and in parallel, the configuration of the illumination systems in the double exposure apparatus can be made more compact.

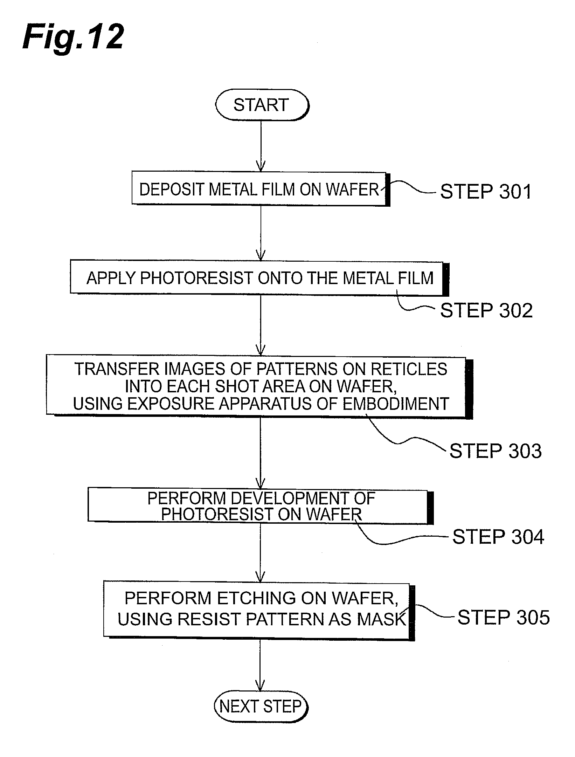

The exposure apparatus of the foregoing embodiment can be used to manufacture micro devices (semiconductor devices, image pickup devices, liquid-crystal display devices, thin-film magnetic heads, etc.) by illuminating a mask (reticle) by the illumination optical apparatus (illumination step) and projecting a pattern to be transferred, formed in the mask, onto a photosensitive substrate through the projection optical system to effect exposure thereof (exposure step). An example of a technique of manufacturing semiconductor devices as micro devices by forming a predetermined circuit pattern in the wafer or the like as a photosensitive substrate by means of the exposure apparatus of the present embodiment will be described below with reference to the flowchart of Fig. 12.

The first step 301 in Fig. 12 is to deposit a metal film on each wafer in one lot. The next step 302 is to apply a photoresist onto the metal film on each wafer in the lot. The subsequent step 303 is to sequentially transfer images of patterns on masks into each shot area on each wafer in the lot through the projection optical system, using the exposure apparatus of the foregoing embodiment. The subsequent step 304 is to perform development of the photoresist on each wafer in the lot and the subsequent step 305 is to perform etching on each wafer in the lot, using the resist pattern as a mask, and thereby to form a circuit pattern corresponding to the patterns on the masks, in each shot area on each wafer.

Subsequent steps include formation of circuit patterns in upper layers, and others, thereby manufacturing devices such as semiconductor devices. The above-described semiconductor device manufacturing method permits us to obtain semiconductor devices with extremely fme circuit patterns at high throughput. The steps 301 to 305 were arranged to perform the steps of depositing the metal on the wafer, applying the resist onto the metal film, and performing the exposure, development, and etching, but it is needless to mention that, prior to these steps, the method may include a process of first forming an oxide film of silicon on the wafer, then applying a resist onto the oxide film of silicon, and performing each of steps such as exposure, development, and etching.

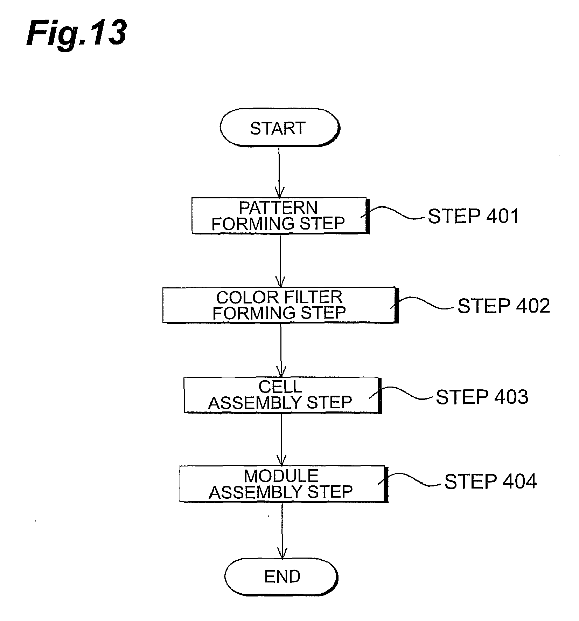

The exposure apparatus of the present embodiment can also be used to manufacture a liquid-crystal display device as a micro device by forming predetermined patterns (circuit pattern, electrode pattern, etc.) on plates (glass substrates). An example of a technique in this case will be described below with reference to the flowchart of Fig. 13. In Fig. 13, a pattern forming step 401 is to execute a so-called photolithography step to transfer patterns of masks onto a photosensitive substrate (glass substrate coated with a resist, or the like), using the exposure apparatus of the present embodiment. This photolithography step results in forming a predetermined pattern including a number of electrodes and others on the photosensitive substrate. Thereafter, the exposed substrate is subjected to each of steps such as development, etching, and resist removal, whereby a predetermined pattern is formed on the substrate. Thereafter, the process shifts to the next color filter forming step 402.

The next color filter forming step 402 is to form a color filter in which a number of sets of three dots corresponding to R (Red), G (Green), and B (Blue) are arrayed in a matrix pattern, or in which sets of three stripe filters of R, G, and B are arrayed as a plurality of lines arranged in the horizontal scan line direction. After completion of the color filter forming step 402, a cell assembling step 403 is carried out. The cell assembling step 403 is to assemble a liquid crystal panel (liquid crystal cell), using the substrate with the predetermined pattern obtained in the pattern forming step 401, the color filter obtained in the color filter forming step 402, and so on.

In the cell assembly step 403, for example, a liquid crystal is poured into between the substrate with the predetermined pattern obtained in the pattern forming step 401 and the color filter obtained in the color filter forming step 402, to manufacture a liquid crystal panel (liquid crystal cell). The subsequent module assembly step 404 is to install each of components such as an electric circuit, a backlight, etc. for display operation of the assembled liquid crystal panel (liquid crystal cell) to complete the liquid-crystal display device. The above-described method of manufacturing the liquid-crystal display device permits us to obtain the liquid-crystal display device with an extremely fme circuit pattern at high throughput.

The above-described embodiment used the KrF excimer laser light source or the ArF excimer laser light source as the light source, but, without having to be limited to them, the present invention is also applicable to the exposure apparatus using any other appropriate light source, e.g., an F₂ laser light source.

## Claims

1. An exposure apparatus comprising:
a first illumination system which illuminates a first region elongated along a first direction, in a pattern region formed in a first mask;
a second illumination system which illuminates a second region elongated along the first direction, in a pattern region formed in a second mask located apart from the first mask along a second direction perpendicular to the first direction; and
a projection optical system which forms a pattern image of the first region and a pattern image of the second region in parallel along the second direction on a photosensitive substrate, or which forms the pattern image of the first region and the pattern image of the second region in accord with each other on the photosensitive substrate;
wherein an optical axis of an exit-side partial optical system of the first illumination system and an optical axis of an exit-side partial optical system of the second illumination system each are set along a plane parallel to the first direction.

2. An exposure apparatus according to claim 1, wherein the exit-side partial optical system of the first illumination system and the exit-side partial optical system of the second illumination system are arranged next to each other and in parallel.

3. An exposure apparatus according to claim 1 or 2, wherein the exit-side partial optical system of the first illumination system and the exit-side partial optical system of the second illumination system have their respective folding members which fold an optical path.

4. An exposure apparatus according to any one of claims 1 to 3, wherein the first illumination system and the second illumination system have their respective configurations identical to each other, and
wherein an optical axis of the entire first illumination system and an optical axis of the entire second illumination system each are set along the plane parallel to the first direction.

5. An exposure apparatus according to any one of claims 1 to 3, wherein the first illumination system and the second illumination system comprise a common light source, and an optical splitter which splits light from the common light source into a light beam traveling toward an optical path of the first illumination system and a light beam traveling toward an optical path of the second illumination system, and
wherein an optical axis of a partial optical system of the first illumination system located between the optical splitter and the first mask and an optical axis of a partial optical system of the second illumination system located between the optical splitter and the second mask each are set along the plane parallel to the first direction.

6. An exposure apparatus comprising:
a first illumination system which illuminates a first region elongated along a first direction, in a pattern region formed in a first mask;
a second illumination system which illuminates a second region elongated along the first direction, in a pattern region formed in a second mask located apart from the first mask along the first direction; and
a projection optical system which forms a pattern image of the first region and a pattern image of the second region in parallel along a second direction perpendicular to the first direction on a photosensitive substrate, or which forms the pattern image of the first region and the pattern image of the second region in accord with each other on the photosensitive substrate;
wherein an optical axis of an exit-side partial optical system of the first illumination system and an optical axis of an exit-side partial optical system of the second illumination system each are set along a plane parallel to the second direction.

7. An exposure apparatus according to claim 6, wherein the exit-side partial optical system of the first illumination system and the exit-side partial optical system of the second illumination system are arranged next to each other and in parallel.

8. An exposure apparatus according to claim 6 or 7, wherein the exit-side partial optical system of the first illumination system and the exit-side partial optical system of the second illumination system have their respective folding members which fold an optical path.

9. An exposure apparatus according to any one of claims 6 to 8, wherein the first illumination system and the second illumination system have their respective configurations identical to each other, and
wherein an optical axis of the entire first illumination system and an optical axis of the entire second illumination system each are set along the plane parallel to the second direction.

10. An exposure apparatus according to any one of claims 6 to 8, wherein the first illumination system and the second illumination system comprise a common light source, and an optical splitter which splits light from the common light source into a light beam traveling toward an optical path of the first illumination system and a light beam traveling toward an optical path of the second illumination system, and
wherein an optical axis of a partial optical system of the first illumination system located between the optical splitter and the first mask and an optical axis of a partial optical system of the second illumination system located between the optical splitter and the second mask each are set along the plane parallel to the second direction.

11. An exposure apparatus according to any one of claims 1 to 10, wherein the first illumination system and the second illumination system have their respective illumination condition varying parts which vary an illumination condition for illumination of the first region and the second region.

12. An exposure apparatus according to claim 11, wherein the illumination condition varying part of the first illumination system is located on the light source side with respect to the exit-side partial optical system of the first illumination system, and
wherein the illumination condition varying part of the second illumination system is located on the light source side with respect to the exit-side partial optical system of the second illumination system.

13. An exposure apparatus according to any one of claims 1 to 10, wherein the first illumination system has a first setting part located on the light source side of the exit-side partial optical system of the first illumination system and adapted to set the first region in a first illumination condition, and
wherein the second illumination system has a second setting part located on the light source side of the exit-side partial optical system of the second illumination system and adapted to set the second region in a second illumination condition.

14. An exposure apparatus according to claim 13, wherein the first setting part has a first illumination condition varying part which varies an illumination condition in the first region, and
wherein the second setting part has a second illumination condition varying part which varies an illumination condition in the second region.

15. An exposure apparatus according to claim 14, wherein the first illumination condition varying part sets a polarization state in the first region and a light intensity distribution on an illumination pupil of the first illumination system, and
wherein the second illumination condition varying part sets a polarization state in the second region and a light intensity distribution on an illumination pupil of the second illumination system.

16. An exposure apparatus according to any one of claims 1 to 15, wherein the pattern image of the first region and the pattern image of the second region have a shape elongated along the first direction.

17. An exposure apparatus according to any one of claims 1 to 16, wherein, when the projection optical system is viewed from right above it along the perpendicular direction, the pattern image of the first region and the pattern image of the second region are formed in a region between the first region formed by the first illumination system and the second region formed by the second illumination system.

18. An exposure apparatus according to any one of claims 1 to 5, wherein an exit-side optical axis of the first illumination system and an exit-side optical axis of the second illumination system each are set along a plane parallel to the first direction and perpendicular to the second direction.

19. An exposure apparatus according to any one of claims 6 to 10, wherein an exit-side optical axis of the first illumination system and an exit-side optical axis of the second illumination system each are set along a plane parallel to the second direction and perpendicular to the first direction.

20. An exposure apparatus comprising:
a first illumination system which illuminates a first mask;
a second illumination system which illuminates a second mask located apart from the first mask along a first direction; and
a projection optical system which forms a pattern image of the first region and a pattern image of the second region in parallel on a photosensitive substrate, or which forms the pattern image of the first region and the pattern image of the second region in accord with each other on the photosensitive substrate;
wherein an exit-side partial optical system of the first illumination system and an exit-side partial optical system of the second illumination system are arranged next to each other and in parallel, and
wherein an optical axis of the exit-side partial optical system of the first illumination system and an optical axis of the exit-side partial optical system of the second illumination system each are set along a plane parallel to a second direction perpendicular to the first direction.

21. An exposure apparatus according to claim 20, wherein the exit-side partial optical system of the first illumination system and the exit-side partial optical system of the second illumination system have their respective folding members which fold an optical path.

22. An exposure apparatus according to claim 20 or 21, wherein the first illumination system illuminates the first mask under a first illumination condition, and wherein the second illumination system illuminates the second mask under a second illumination condition different from the first illumination condition.

23. An exposure apparatus according to any one of claims 20 to 22, wherein the first illumination system has a first illumination condition varying part which varies an illumination condition for illumination of the first mask, on the light source side of the exit-side partial optical system of the first illumination system, and
wherein the second illumination system has a second illumination condition varying part which varies an illumination condition for illumination of the second mask, on the light source side of the exit-side partial optical system of the second illumination system.

24. An exposure apparatus according to any one of claims 20 to 22, wherein the first illumination system has a first setting part which sets an illumination condition for illumination of the first mask, on the light source side of the exit-side partial optical system of the first illumination system, and
wherein the second illumination system has a second setting part which sets an illumination condition for illumination of the second mask, on the light source side of the exit-side partial optical system of the second illumination system.

25. An exposure apparatus according to claim 24, wherein the first setting part has a first illumination condition varying part which varies an illumination condition for illumination of the first mask, and
wherein the second setting part has a second illumination condition varying part which varies an illumination condition for illumination of the second mask.

26. An exposure apparatus according to claim 25, wherein the first illumination condition varying part sets a polarization state on the first mask and a light intensity distribution on an illumination pupil of the first illumination system, and
wherein the second illumination condition varying part sets a polarization state on the second mask and a light intensity distribution on an illumination pupil of the second illumination system.

27. An exposure apparatus according to any one of claims 20 to 26, comprising a light source which supplie light, and an optical splitter which splits the light from the light source into a light beam traveling toward the first illumination system and a light beam traveling toward the second illumination system.

28. An exposure apparatus according to any one of claims 20 to 26, comprising a first light source which guides light to the first illumination system, and a second light source which guides light to the second illumination system.

29. An exposure apparatus according to any one of claims 20 to 28, wherein the first illumination system and the second illumination system are arranged next to each other and in parallel.

30. A device manufacturing method comprising:
an exposure step of using the exposure apparatus as set forth in any one of claims 1 to 29, to effect exposure of a pattern of the first mask and a pattern of the second mask on the photosensitive substrate; and
a development step of effecting development of the photosensitive substrate after the exposure step.

31. An exposure method of using the exposure apparatus as set forth in any one of claims 1 to 29, to effect exposure of a pattern of the first mask and a pattern of the second mask on the photosensitive substrate,
wherein, while moving the first mask, the second mask, and the photosensitive substrate along the second direction, scanning exposure of the pattern of the first mask and the pattern of the second mask is effected in a unit exposure region on the photosensitive substrate.

32. An exposure method of using the exposure apparatus as set forth in any one of claims 1 to 29, to effect exposure of a pattern of the first mask and a pattern of the second mask on the photosensitive substrate,
wherein, while moving the first mask, the second mask, and the photosensitive substrate along the second direction, scanning exposure of the pattern of the first mask is effected in one unit exposure region on the photosensitive substrate, and scanning exposure of the pattern of the second mask is effected in another unit exposure region located apart from said one unit exposure region along the second direction.

33. An illumination apparatus comprising:
a first illumination system which illuminates a first region elongated along a first direction, in a pattern region formed in a first mask; and
a second illumination system which illuminates a second region elongated along the first direction, in a pattern region formed in a second mask located apart from the first mask along a second direction perpendicular to the first direction;
wherein an optical axis of an exit-side partial optical system of the first illumination system and an optical axis of an exit-side partial optical system of the second illumination system each are set along a plane parallel to the first direction, and
wherein the exit-side partial optical system of the first illumination system and the exit-side partial optical system of the second illumination system are arranged next to each other and in parallel.

34. An illumination apparatus comprising:
a first illumination system which illuminates a first region elongated along a first direction, in a pattern region formed in a first mask; and
a second illumination system which illuminates a second region elongated along the first direction, in a pattern region formed in a second mask located apart from the first mask along the first direction;
wherein an optical axis of an exit-side partial optical system of the first illumination system and an optical axis of an exit-side partial optical system of the second illumination system each are set along a plane parallel to a second direction perpendicular to the first direction, and
wherein the exit-side partial optical system of the first illumination system and the exit-side partial optical system of the second illumination system are arranged next to each other and in parallel.

35. An illumination apparatus according to claim 33 or 34, wherein the exit-side partial optical system of the first illumination system and the exit-side partial optical system of the second illumination system have their respective folding members which fold an optical path.

36. An illumination apparatus according to any one of claims 33 to 35, wherein the first illumination system has a first illumination condition varying part located on the light source side with respect to the exit-side partial optical system of the first illumination system and adapted to vary an illumination condition for illumination of the first region, and
wherein the second illumination system has a second illumination condition varying part located on the light source side with respect to the exit-side partial optical system of the second illumination system and adapted to vary an illumination condition for illumination of the first region.

37. An illumination apparatus according to any one of claims 33 to 35, wherein the first illumination system has a first setting part located on the light source side of the exit-side partial optical system of the first illumination system and adapted to set the first region in a first illumination condition, and
wherein the second illumination system has a second setting part located on the light source side of the exit-side partial optical system of the second illumination system and adapted to set the second region in a second illumination condition.

38. An illumination apparatus according to claim 37, wherein the first setting part has a first illumination condition varying part which varies an illumination condition in the first region, and
wherein the second setting part has a second illumination condition varying part which varies an illumination condition in the second region.

39. An illumination apparatus according to claim 38, wherein the first illumination condition varying part sets a polarization state in the first region and a light intensity distribution on an illumination pupil of the first illumination system, and
wherein the second illumination condition varying part sets a polarization state in the second region and a light intensity distribution on an illumination pupil of the second illumination system.

40. A device manufacturing method comprising:
an exposure step of using the illumination apparatus as set forth in any one of claims 33 to 39, to effect exposure of a pattern of the first mask and a pattern of the second mask on the photosensitive substrate; and
a development step of effecting development of the photosensitive substrate after the exposure step.

## Amended claims

### Amended claims under Art. 19.1 PCT

1. An optical system comprising:
a first illumination system which illuminates a first region elongated along a first direction in a first plane;
a second illumination system which illuminates a second region elongated along the first direction, located apart from the first region along a second direction perpendicular to the first direction in the first plane; and
a projection optical system which forms an image of the first region and an image of the second region in parallel along the second direction on a second plane, or which forms the image of the first region and the image of the second region in accord with each other on the second plane;
wherein an optical axis of an exit-side partial optical system of the first illumination system and an optical axis of an exit-side partial optical system of the second illumination system each are set along a plane parallel to the first direction.

2. An optical system according to claim 1, wherein the exit-side partial optical system of the first illumination system and the exit-side partial optical system of the second illumination system are arranged next to each other and in parallel.

3. An optical system according to claim 1 or 2, wherein the exit-side partial optical system of the first illumination system and the exit-side partial optical system of the second illumination system have their respective folding members which fold an optical path.

4. An optical system according to any one of claims 1 to 3, wherein the first illumination system and the second illumination system have their respective configurations identical to each other, and
wherein an optical axis of the entire first illumination system and an optical axis of the entire second illumination system each are set along the plane parallel to the first direction.

5. An optical system according to any one of claims 1 to 3, wherein the first illumination system and the second illumination system comprise an optical splitter which splits light from a common light source into a light beam traveling toward an optical path of the first illumination system and a light beam traveling toward an optical path of the second illumination system, and
wherein an optical axis of a partial optical system of the first illumination system located between the optical splitter and the first region and an optical axis of a partial optical system of the second illumination system located between the optical splitter and the second region each are set along the plane parallel to the first direction.

6. An optical system comprising:
a first illumination system which illuminates a first region elongated along a first direction in a first plane;
a second illumination system which illuminates a second region elongated along the first direction, located apart from the first region along the first direction in the first plane; and
a projection optical system which forms an image of the first region and an image of the second region in parallel along a second direction perpendicular to the first direction on a second plane, or which forms the image of the first region and the image of the second region in accord with each other on the second plane;
wherein an optical axis of an exit-side partial optical system of the first illumination system and an optical axis of an exit-side partial optical system of the second illumination system each are set along a plane parallel to the second direction.

7. An optical system according to claim 6, wherein the exit-side partial optical system of the first illumination system and the exit-side partial optical system of the second illumination system are arranged next to each other and in parallel.

8. An optical system according to claim 6 or 7, wherein the exit-side partial optical system of the first illumination system and the exit-side partial optical system of the second illumination system have their respective folding members which fold an optical path.

9. An optical system according to any one of claims 6 to 8, wherein the first illumination system and the second illumination system have their respective configurations identical to each other, and
wherein an optical axis of the entire first illumination system and an optical axis of the entire second illumination system each are set along the plane parallel to the second direction.

10. An optical system according to any one of claims 6 to 8,
wherein the first illumination system and the second illumination system comprise an optical splitter which splits light from a common light source into a light beam traveling toward an optical path of the first illumination system and a light beam traveling toward an optical path of the second illumination system, and
wherein an optical axis of a partial optical system of the first illumination system located between the optical splitter and the first region and an optical axis of a partial optical system of the second illumination system located between the optical splitter and the second region each are set along the plane parallel to the second direction.

11. An optical system according to any one of claims 1 to 10, wherein the first illumination system and the second illumination system have their respective illumination condition varying parts which vary an illumination condition for illumination of the first region and the second region.

12. An optical system according to claim 11, wherein the illumination condition varying part of the first illumination system is located on the light-entering-side with respect to the exit-side partial optical system of the first illumination system, and
wherein the illumination condition varying part of the second illumination system is located on the light-entering-side with respect to the exit-side partial optical system of the second illumination system.

13. An optical system according to any one of claims 1 to 10, wherein the first illumination system has a first setting part located on the light-entering-side of the exit-side partial optical system of the first illumination system and adapted to set the first region in a first illumination condition, and
wherein the second illumination system has a second setting part located on the light-entering-side of the exit-side partial optical system of the second illumination system and adapted to set the second region in a second illumination condition.

14. An optical system according to claim 13, wherein the first setting part has a first illumination condition varying part which varies an illumination condition in the first region, and
wherein the second setting part has a second illumination condition varying part which varies an illumination condition in the second region.

15. An optical system according to claim 14, wherein the first illumination condition varying part sets a polarization state in the first region and a light intensity distribution on an illumination pupil of the first illumination system, and
wherein the second illumination condition varying part sets a polarization state in the second region and a light intensity distribution on an illumination pupil of the second illumination system.

16. An optical system according to any one of claims 1 to 15, wherein the image of the first region and the image of the second region have a shape elongated along the first direction.

17. An optical system according to any one of claims 1 to 16, wherein, when the projection optical system is viewed from right above it along the perpendicular direction, the image of the first region and the image of the second region are formed in a region between the first region formed by the first illumination system and the second region formed by the second illumination system.

18. An optical system according to any one of claims 1 to 5, wherein an exit-side optical axis of the first illumination system and an exit-side optical axis of the second illumination system each are set along a plane parallel to the first direction and perpendicular to the second direction.

19. An optical system according to any one of claims 6 to 10, wherein an exit-side optical axis of the first illumination system and an exit-side optical axis of the second illumination system each are set along a plane parallel to the second direction and perpendicular to the first direction.

20. An exposure apparatus comprising an illumination apparatus according to any one of claims 1 to 19,
wherein a first pattern located on the first plane is illuminated with the first region and a second pattern located on the first plane is illuminated with the second region, and
wherein a pattern image of the first region and a pattern image of the second region are formed in parallel on a photosensitive substrate located on the second plane, or a pattern image of the first region and a pattern image of the second region are formed in accord with each other on the photosensitive substrate.

21. An exposure apparatus according to claim 20, wherein the first pattern is formed in a pattern region on the first mask and the second pattern is formed in a pattern region on the second mask.

22. An exposure apparatus comprising:
a first illumination system which illuminates a first mask;
a second illumination system which illuminates a second mask located apart from the first mask along a first direction; and
a projection optical system which forms a pattern image of the first region and a pattern image of the second region in parallel on a photosensitive substrate, or which forms the pattern image of the first region and the pattern image of the second region in accord with each other on the photosensitive substrate;
wherein an exit-side partial optical system of the first illumination system and an exit-side partial optical system of the second illumination system are arranged next to each other and in parallel, and
wherein an optical axis of the exit-side partial optical system of the first illumination system and an optical axis of the exit-side partial optical system of the second illumination system each are set along a plane parallel to a second direction perpendicular to the first direction.

23. An exposure apparatus according to claim 22, wherein the exit-side partial optical system of the first illumination system and the exit-side partial optical system of the second illumination system have their respective folding members which fold an optical path.

24. An exposure apparatus according to claim 22 or 23, wherein the first illumination system illuminates the first mask under a first illumination condition, and wherein the second illumination system illuminates the second mask under a second illumination condition different from the first illumination condition.

25. An exposure apparatus according to any one of claims 22 to 24, wherein the first illumination system has a first illumination condition varying part which varies an illumination condition for illumination of the first mask, on the light-entering-side of the exit-side partial optical system of the first illumination system, and
wherein the second illumination system has a second illumination condition varying part which varies an illumination condition for illumination of the second mask, on the light-entering-side of the exit-side partial optical system of the second illumination system.

26. An exposure apparatus according to any one of claims 22 to 24, wherein the first illumination system has a first setting part which sets an illumination condition for illumination of the first mask, on the light-entering-side of the exit-side partial optical system of the first illumination system, and
wherein the second illumination system has a second setting part which sets an illumination condition for illumination of the second mask, on the light-entering-side of the exit-side partial optical system of the second illumination system.

27. An exposure apparatus according to claim 26, wherein the first setting part has a first illumination condition varying part which varies an illumination condition for illumination of the first mask, and
wherein the second setting part has a second illumination condition varying part which varies an illumination condition for illumination of the second mask.

28. An exposure apparatus according to claim 27, wherein the first illumination condition varying part sets a polarization state on the first mask and a light intensity distribution on an illumination pupil of the first illumination system, and
wherein the second illumination condition varying part sets a polarization state on the second mask and a light intensity distribution on an illumination pupil of the second illumination system.

29. An exposure apparatus according to any one of claims 22 to 28, comprising a light source which supplie light, and an optical splitter which splits the light from the light source into a light beam traveling toward the first illumination system and a light beam traveling toward the second illumination system.

30. An exposure apparatus according to any one of claims 22 to 28, comprising a first light source which guides light to the first illumination system, and a second light source which guides light to the second illumination system.

31. An exposure apparatus according to any one of claims 22 to 30, wherein the first illumination system and the second illumination system are arranged next to each other and in parallel.

32. A device manufacturing method comprising:
an exposure step of using the exposure apparatus as set forth in any one of claims 21 to 31, to effect exposure of a pattern of the first mask and a pattern of the second mask on the photosensitive substrate; and
a development step of effecting development of the photosensitive substrate after the exposure step.

33. An exposure method of using the exposure apparatus as set forth in any one of claims 21 to 31, to effect exposure of a pattern of the first mask and a pattern of the second mask on the photosensitive substrate,
wherein, while moving the first mask, the second mask, and the photosensitive substrate along the second direction, scanning exposure of the pattern of the first mask and the pattern of the second mask is effected in a unit exposure region on the photosensitive substrate.

34. An exposure method of using the exposure apparatus as set forth in any one of claims 21 to 31, to effect exposure of a pattern of the first mask and a pattern of the second mask on the photosensitive substrate,
wherein, while moving the first mask, the second mask, and the photosensitive substrate along the second direction, scanning exposure of the pattern of the first mask is effected in one unit exposure region on the photosensitive substrate, and scanning exposure of the pattern of the second mask is effected in another unit exposure region located apart from said one unit exposure region along the second direction.

35. An illumination apparatus comprising:
a first illumination system which illuminates a first region elongated along a first direction on a first plane; and
a second illumination system which illuminates a second region elongated along the first direction, located apart from the first region along a second direction perpendicular to the first direction on the first plane;
wherein an optical axis of an exit-side partial optical system of the first illumination system and an optical axis of an exit-side partial optical system of the second illumination system each are set along a plane parallel to the first direction, and
wherein the exit-side partial optical system of the first illumination system and the exit-side partial optical system of the second illumination system are arranged next to each other and in parallel.

36. An illumination apparatus comprising:
a first illumination system which illuminates a first region elongated along a first direction on a first plane; and
a second illumination system which illuminates a second region elongated along the first direction, located apart from the first region along a second direction perpendicular to the first direction on the first plane;
wherein an optical axis of an exit-side partial optical system of the first illumination system and an optical axis of an exit-side partial optical system of the second illumination system each are set along a plane parallel to a second direction perpendicular to the first direction, and
wherein the exit-side partial optical system of the first illumination system and the exit-side partial optical system of the second illumination system are arranged next to each other and in parallel.

37. An illumination apparatus according to claim 35 or 36, wherein the exit-side partial optical system of the first illumination system and the exit-side partial optical system of the second illumination system have their respective folding members which fold an optical path.

38. An illumination apparatus according to any one of claims 35 to 37, wherein the first illumination system has a first illumination condition varying part located on the light-entering-side with respect to the exit-side partial optical system of the first illumination system and adapted to vary an illumination condition for illumination of the first region, and
wherein the second illumination system has a second illumination condition varying part located on the light-entering-side with respect to the exit-side partial optical system of the second illumination system and adapted to vary an illumination condition for illumination of the first region.

39. An illumination apparatus according to any one of claims 35 to 37, wherein the first illumination system has a first setting part located on the light-entering-side of the exit-side partial optical system of the first illumination system and adapted to set the first region in a first illumination condition, and
wherein the second illumination system has a second setting part located on the light-entering-side of the exit-side partial optical system of the second illumination system and adapted to set the second region in a second illumination condition.

40. An exposure apparatus according to claim 39, wherein the first setting part has a first illumination condition varying part which varies an illumination condition in the first region, and
wherein the second setting part has a second illumination condition varying part which varies an illumination condition in the second region.

41. An exposure apparatus according to claim 40, wherein the first illumination condition varying part sets a polarization state in the first region and a light intensity distribution on an illumination pupil of the first illumination system, and
wherein the second illumination condition varying part sets a polarization state in the second region and a light intensity distribution on an illumination pupil of the second illumination system.

42. A device manufacturing method comprising:
an exposure step of using the illumination apparatus as set forth in any one of claims 35 to 41, to effect exposure of a pattern of the first mask located on the first plane and a pattern of the second mask located on the first plane on the photosensitive substrate; and
a development step of effecting development of the photosensitive substrate after the exposure step.
